(19) Europäisches Patentamt
European Patent Office
Office européen des brevets

(11) EP 2 363 904 A2

(12) **EUROPEAN PATENT APPLICATION**

(43) Date of publication:
**07.09.2011 Bulletin 2011/36**

(21) Application number: **11250234.9**

(22) Date of filing: **01.03.2011**

(51) Int Cl.:
***H01L 51/05*** *(2006.01)* ***H01L 51/10*** *(2006.01)*
***H01L 51/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **02.03.2010 JP 2010044937**
**02.03.2010 JP 2010044938**
**02.03.2010 JP 2010044939**

(71) Applicants:
- **Ricoh Company, Limited**
  **Tokyo 143-8555 (JP)**
- **Kyushu University**
  **Fukuoka-shi**
  **Fukuoka (JP)**

(72) Inventors:
- **Kato, Takuji**
  **Tokyo (JP)**
- **Yamamoto, Satoshi**
  **Tokyo (JP)**
- **Sagisaka, Toshiya**
  **Tokyo (JP)**
- **Tano, Takanori**
  **Tokyo (JP)**
- **Shinoda, Masato**
  **Tokyo (JP)**
- **Goto, Daisuke**
  **Tokyo (JP)**
- **Matsumoto, Shinji**
  **Tokyo (JP)**
- **Mohri, Masataka**
  **Tokyo (JP)**
- **Yutani, Keiichiro**
  **Tokyo (JP)**
- **Adachi, Chihaya**
  **Tokyo (JP)**
- **Torii, Masafumi**
  **Tokyo (JP)**

(74) Representative: **Lamb, Martin John Carstairs**
**Marks & Clerk LLP**
**90 Long Acre**
**London**
**WC2E 9RA (GB)**

(54) **Organic semiconductor element and organic electrode**

(57) To provide an organic semiconductor element, containing: a source electrode containing a first organic compound layer and a second organic compound layer, at least one of the layers having an organic semiconductor active region; and a drain electrode containing the first organic compound layer and the second organic compound layer, as well as providing an organic electrode, containing: a laminated film, in which a layer of a tetrathiafulvalene derivative expressed by the following general formula I and a layer of an electron-accepting compound are laminated:

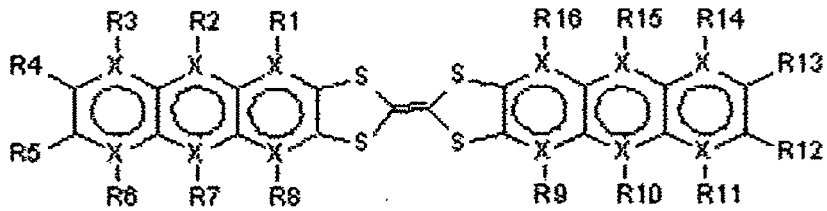

General formula I

EP 2 363 904 A2

FIG. 1A

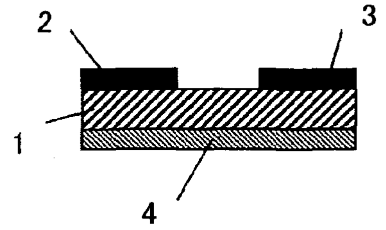


FIG. 1B

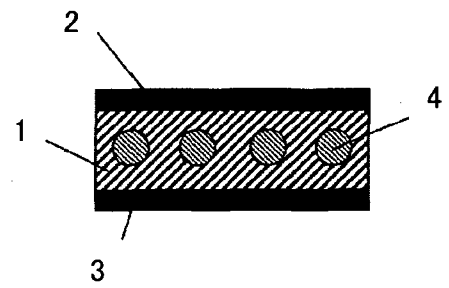


FIG. 1C

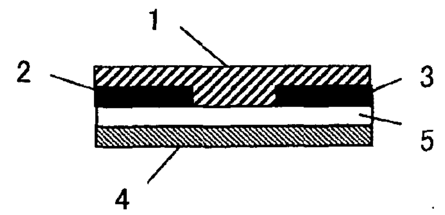


FIG. 1D

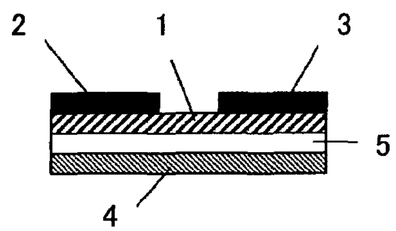

## Description

BACKGROUND OF THE INVENTION

Field of the Invention

The present invention relates to an organic semiconductor element and an organic electrode, applications of which are expected in organic electronic devices such as organic conductors, organic superconductors, organic magnetic materials, organic thermoelectric elements, organic electrochromic elements, and organic electroluminescence elements.

Description of the Related Art

Organic electronic devices have excellent flexibility, and portability, and hence it is expected that the utility value of the organic electronic devices will be increased even more. For this reason, developments and researches have been actively conducted on devices that are main parts of organic electronics, such as organic semiconductors, organic LED, and organic solar batteries. Organic materials are originally insulating materials, and hence in these devices metals are used in most of electrode regions. Therefore, in order to make use of characteristics of an organic compound, such as flexibility and portability, a development of an organic electrode applicable to organic electronics has been desired.
A charge-transfer complex formed of an electron-donating molecule and an electron-accepting molecule has been known as an example showing a possibility of an organic electrode. The metal-like conductivity of this charge-transfer complex was evidenced with tetrathiafulvalene (TTF)-tetracyanoquinodimethane (TCNQ) in 1973, and since then new materials have been developed such as BDTTF, and TSF, and $F_1$TCNQ, $F_2$TCNQ, and $F_4$TCNQ presented below (see Appl. Phys. Lett., 88, 073504, (2006), and Adv. Materials, 2007, 19, 3248). Moreover, there is an expectation to apply this charge-transfer complex in various fields, such as use in organic superconductors, organic magnetic materials, organic electrochromic elements, organic electroluminescence elements, and organic thermoelectric elements.

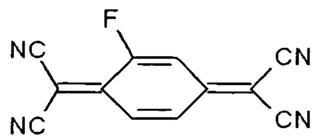
$F_1$TCNQ

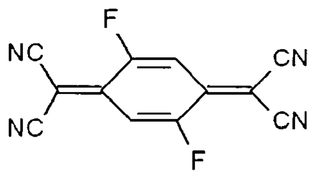
$F_2$TCNQ

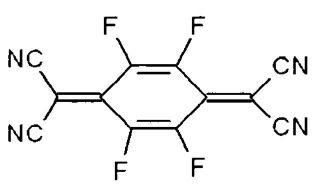
$F_4$TCNQ

As the known example of the charge-transfer complex used as an organic element, there are an example in which TTF-TCNQ are codeposited and arranged on a BDTTF-TCNQ mixed crystal having characteristics of p-type semiconductor in the shape of an electrode (see Appl. Phys. Lette., 88, 073504, (2006)), and an example in which a layer of TTF-TCNQ is formed on a deposited film of pentacene by inkjet coating (see Chem. Matter, 19, 6382, (2007)).
However, the example where TTF-TCNQ is arranged in the form of an electrode by codeposition uses the BDTTF-TCNQ mixed crystal for an organic semiconductor active layer, and because of its specialty this has not been

yet realized in practice. Moreover, for the example using the inkjet coating, the electron-donating compound and electron-accepting compound formed as an ink need to be soluble to an ink solvent, but organic materials used for an organic semiconductor active layer need to have resistance to the ink solvent, and thus a combination of suitable materials has not yet been found, which is a great difficulty to make it to practical use. Furthermore, in inkjet coating, a micrometer-order positioning accuracy is required, and thus it cannot avoid use of a large-scale facility. Therefore, further developments are desired including a development of a novel organic semiconductor element structure.

Another problem in the art is that an organic semiconductor element itself has only a function of controlling current. In order to use the organic semiconductor element in applications, the organic semiconductor element is desired to have a function of an electric circuit, by providing both a p-type organic semiconductor and an n-type organic semiconductor on one application substrate. The realization of an application using an organic semiconductor is currently a great challenge to achieve.

BRIEF SUMMARY OF THE INVENTION

Considering the current situations in the related art, an object of the present invention is to provide an organic semiconductor element of high process ability, which is capable of producing both a p-type and n-type organic thin-film transistor with the same material, i.e., two organic compounds, and is capable of producing an organic electrode at the same time as the transistor, as well as providing an electric circuit using such organic semiconductor element. Moreover, another object of the present invention is to provide an organic electrode of a simple structure and high electric conductivity by only laminating an electron-donating compound and an electron-accepting compound. These can be applied to organic conductors, organic superconductors, organic magnetic materials, organic thermoelectric elements, organic electrochromic elements, and organic electroluminescence elements.

The present inventors conducted diligent studies and researches to achieve the aforementioned objects, and found that both p-type and n-type organic semiconductor element can be produced by using two compounds to form a single layer from the respective compound (i.e. two layers in total), as well as forming an organic electrode at the same time. The present inventors found that in such manner an organic semiconductor element of high flexibility can be easily obtained.

Especially, it is preferred that the organic compounds for forming the organic electrode contain at least a combination of one electron-donating organic compound and one electron-accepting compound for forming a charge-transfer complex. As one of examples of the particularly preferable electron-donating compound, a tetrathiafulvalene derivative expressed by the following general formula I, which exhibits strong electron-donating properties, is provided. Moreover, one of examples of the particularly preferable electron-accepting compound, fullerene, which exhibits strong electron-accepting properties, is provided.

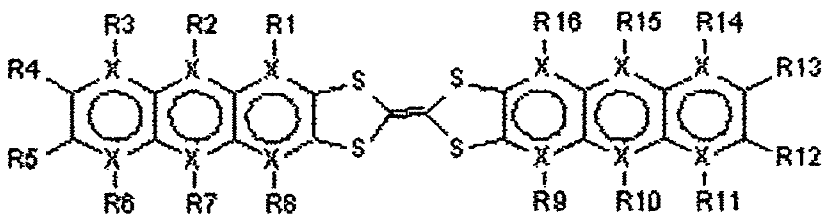

General Formula I

In the general formula I above, X is a carbon atom, a sulfur atom, or a nitrogen atom, and a plurality of X are the same or different from each other; and R1 to R16 are each a hydrogen atom, a halogen atom, a substituted or unsubstituted alkyl group, a substituted or unsubstituted alkoxy group, or a substituted or unsubstituted thioalkoxy group, and are the same or different from each other, provided that X is the carbon atom or the nitrogen atom.

Furthermore, an organic semiconductor element can effectively used for and easily produce electric circuits, such as inverter circuits, because a n-type organic semiconductor and a p-type organic semiconductor can be selectively produced with the combination of the electron-donating compound and the electron-accepting compound, by merely selecting the electron-donating compound or the electron-accepting compound for forming into an electrode shape.

Namely, the present invention includes the organic semiconductor element and organic electrode according to the following <1> to <6>:

<1> An organic semiconductor element, containing:

a source electrode containing a first organic compound layer and a second organic compound layer, at least one of the layers having an organic semiconductor active region; and
a drain electrode containing the first organic compound layer and the second organic compound layer.

<2> The organic semiconductor element according to <1>, wherein the first and second organic compounds are a combination of one electron-donating compound and one electron-accepting compound.
<3> The organic semiconductor element according to <2>, wherein the electron-donating compound is a tetrathiafulvalene derivative expressed by the following general formula I:

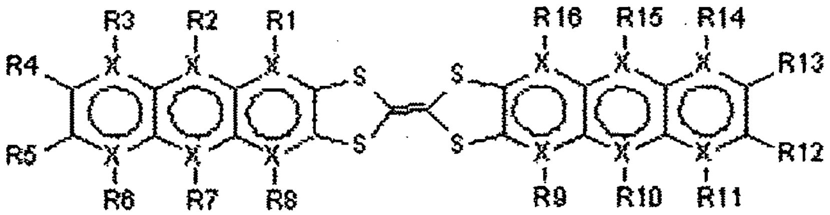

General formula I

where X is a carbon atom, a sulfur atom, or a nitrogen atom, and a plurality of X are the same or different from each other; and R1 to R16 are each a hydrogen atom, a halogen atom, a substituted or unsubstituted alkyl group, a substituted or unsubstituted alkoxy group, or a substituted or unsubstituted thioalkoxy group, and are the same or different from each other, provided that X is the carbon atom or the nitrogen atom.
<4> The organic semiconductor element according to any of <2> or
<3>, wherein the electron-accepting compound is fullerene.
<5> An organic electrode, containing:

a laminated film, in which a layer of a tetrathiafulvalene derivative expressed by the following general formula I and a layer of an electron-accepting compound are laminated:

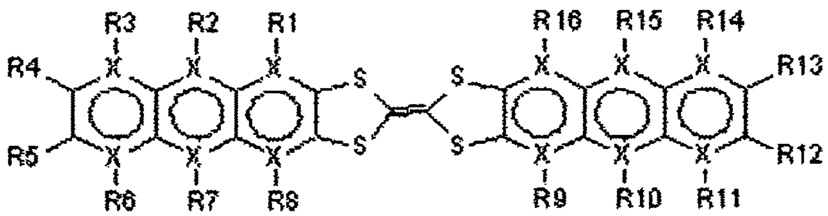

General formula I

where X is a carbon atom, a sulfur atom, or a nitrogen atom, and a plurality of X are the same or different from each other; and R1 to R16 are each a hydrogen atom, a halogen atom, a substituted or unsubstituted alkyl group, a substituted or unsubstituted alkoxy group, or a substituted or unsubstituted thioalkoxy group, and are the same or different from each other, provided that X is the carbon atom or the nitrogen atom.
<6> The organic electrode according to <5>, wherein the electron-accepting compound is fullerene.

According to the present invention, both p-type and n-type organic semiconductor elements can be selectively produced with two organic compounds each, as well as forming an organic electrode at the same time, and hence organic semiconductor element of high process ability as well as electric circuits using the same can be provided. Specifically, there is provided an organic semiconductor element of high process ability, which realizes the formation of both p-type and n-type organic semiconductor elements and organic electrode using only two organic materials.

Moreover, an organic electrode of a simple structure and high electric conductivity can be easily provided by simply laminating a layer of an electron-donating compound and a layer of an electron-accepting compound, and thus is particularly effective for organic wirings or the like. Furthermore, such organic conductive laminated film has excellent as it can be applied for organic conductors, organic superconductors, organic magnetic materials, organic thermoelectric elements, organic electrochromic elements, organic electroluminescence elements, and the like.

BRIEF DESCRIPTION OF THE DRAWINGS

FIGs. 1A to 1D are each a schematic diagram illustrating one example of the organic semiconductor element of the present invention.

FIGs. 2A and 2B is a schematic top view illustrating probing positions of a source electrode and a drain electrode for evaluation of properties of the organic semiconductor used in the present invention.

FIG. 3 is a graph illustrating a current-voltage (I-V) characteristics of the organic semiconductor element at the probing position 1, where the organic semiconductor element has been produced by forming a layer of tetrathiafulvalene derivative as a first organic compound layer, and forming a layer of fullerene as a second compound layer in the shape of an electrode on the first organic compound layer.

FIG. 4 is a graph illustrating a current-voltage (I-V) characteristics of the organic semiconductor element at the probing position 2, where the organic semiconductor element has been produced by forming a layer of tetrathiafulvalene derivative as a first organic compound layer, and forming a layer of fullerene as a second compound layer in the shape of an electrode on the first organic compound layer.

FIG. 5 is a graph illustrating a current-voltage (I-V) characteristics of the organic semiconductor element at the probing position 1, where the organic semiconductor element has been produced by forming a layer of tetrathiafulvalene derivative (i.e. a first organic compound layer) in the shape of an electrode, and forming a layer of fullerene (i.e., a second organic compound layer) on the first organic compound layer.

FIGs. 6A to 6C are schematic diagrams specifically illustrating a production method in which a p-type and n-type organic semiconductor active regions and an organic electrode are simultaneously formed using two organic compounds.

FIG. 7 is a graph illustrating a current-voltage (I-V) characteristics of a laminated film of bis(anthra[2,3-d]) tetrathiafulvalene and fullerene.

FIG. 8 is a graph illustrating a current-voltage (I-V) characteristics of a laminated film of 5,5'-bis(4-hexyloxyphenyl)-2,2'-bithiophene and fullerene.

FIG. 9 is a graph illustrating a current-voltage (I-V) characteristics of an organic thin-film transistor at the probing position 1, where the organic thin-film transistor contains an organic electrode of a tetrathiafulvalene derivative-fullerene laminate that is used for a source electrode and a drain electrode, and pentacene that is used for an organic semiconductor active layer.

FIG. 10 is a graph illustrating a current-voltage (I-V) characteristics of an organic thin-film transistor at the probing position 1, where the organic thin-film transistor contains an organic electrode of a tetrathiafulvalene derivative-fullerene laminate that is used for a source electrode and a drain electrode, and bis(anthra[2,3-d]) tetrathiafulvalene that is used for an organic semiconductor active layer.

FIG. 11 is a graph illustrating a current-voltage (I-V) characteristics of an organic thin-film transistor at the probing position 1, where the organic thin-film transistor contains an organic electrode of a tetrathiafulvalene derivative-fullerene laminate that is used for a source electrode and a drain electrode, and fullerene that is used for an organic semiconductor active layer.

FIG. 12 is a graph illustrating a current-voltage (I-V) characteristics of an organic thin-film transistor at the probing position 2, where the organic thin-film transistor contains an organic electrode of a tetrathiafulvalene derivative-fullerene laminate that is used for a source electrode and a drain electrode, and fullerene that is used for an organic semiconductor active layer.

DETAILED DESCRIPTION OF THE INVENTION

One of the features of the present invention is to provide an organic semiconductor element, such as an organic thin-film transistor, in which two organic compounds (i.e. a first organic compound and a second organic compound) are each formed into a layer and both layers (i.e. a first organic compound layer and a second organic compound layer) are laminated to give functions of an organic electrode, in the region where an electrode is provided, and only one of the two organic compounds is provided in the organic semiconductor active region to give functions of the organic semiconductor active region. It is particularly preferred that the two organic compounds (i.e. the first organic compound

and the second organic compound) are a combination of an electron-donating compound and an electron-accepting compound because use of such combination can be expected to efficiently form a electron-transfer complex at an interface between the layer of the electron-donating compound and the layer of the charge-accepting compound. Furthermore, the electron-donating compound is preferably a tetrathiafulvalene derivative expressed by the general formula I because of its high electron-donating ability.

As known from a tetrathiafulvalene

(TTF)-tetracyanoquinodimethane (TCNQ) charge-transfer complex, the tetrathiafulvalene structure exhibits strong electron-donating ability as it has 7 pi-electrons at its heterocycle and prone to become 6II, which satisfies Hueckel's rule, with releasing one electron. Due to this electron-donating ability, it tends to easily become a radical cation, and the tetrathiafulvalene structure is stable in the state of the radical cation. Accordingly, a charge-transfer complex can be easily formed by laminating a layer of an electron-accepting compound on the layer of the tetrathiafulvalene derivative. However, the conventional tetrathiafulvalene derivative has excessively low ionic potential because of the strong electron-donating ability, which causes poor oxygen resistance. To compare with the conventional tetrathiafulvalene derivative, the material expressed by the general formula (I) has a molecular structure having the extended conjugated system. It may be suggested that there is a possibility of slightly weakening the electron-donating ability of the tetrathiafulvalene derivative due to the extended conjugated system. However, such influence is not seen as much. In contrast, it can be expected to have a large merit that stability of the tetrathiafulvalene derivative expressed by the general formula I to oxygen, which causes deteriorations, improves compared to the conventional tetrathiafulvalene derivative.

Furthermore, the tetrathiafulvalene derivative expressed by the general formula I has a desirable film formability to form a smooth film by vacuum deposition. The tetrathiafulvalene derivative expressed by the general formula I can be used to efficiently form a charge-transfer complex only by laminating a layer of the tetrathiafulvalene derivative and a layer of the electron-accepting compound without using the technique of codeposition. Moreover, as the tetrathiafulvalene derivative has the extended conjugated system of the molecule thereof, there is a large area of passes of charge transfer, by which excellent hole-transporting ability thereof can be expected.

The electron-accepting material represented by fullerene tends to in the stable state of radical anion, and thus in combination with the aforementioned electron-donating compound formations of a charge-transfer complex can be expected as well as giving desirable electron-transporting ability.

Because of excellent hole-transporting ability of the electron-donating compound and excellent electron-transporting ability of the electron-accepting compound, the combination of only these materials can be used as an organic semiconductor active region of a p-type and n-type organic semiconductors. Namely, a source electrode, a drain electrode, and an organic semiconductor active region can be formed by using only two organic materials.

<Structure of Organic Semiconductor Element>

FIGs. 1A to 1D are each a schematic diagram illustrating an example of the organic semiconductor element of the present invention. In the organic semiconductor element of the present invention, the contact interface between a layer formed of the first organic compound 1, and layers each formed of the organic compound 2, 3, is set apart in terms of a space. One side thereof functions as a source electrode, and the other side thereof functions as a drain electrode. Moreover, a space by which the contact interface is separated, i.e. a region between the source electrode and the drain electrode, functions as an organic semiconductor active region.

Moreover, at least one face of the organic semiconductor active region is in contact with a gate electrode 4, or in contact with the gate electrode via a gate insulating film 5. The gate electrode 4 and the gate insulating film 5 are not necessarily present only within the plane where the organic semiconductor active region is present, and can be extended as long as they are provided on a plane to which the electron-donating compound layer or electron-accepting compound layer is provided.

In the organic semiconductor element, electric current running through the organic semiconductor active region provided between the source electrode and drain electrode is controlled by applying a voltage to the gate electrode 4.

The organic semiconductor element of the present invention can be provided on a support, and as the support, for example a conventional support such as of glass, silicon, plastic, or the like can be used. Moreover, it is also possible to use a conductive support so as to give the support a function of a gate electrode, or use a support having a structure in which a gate electrode and a conductive substrate are laminated. However, in the case where a device to which the organic semiconductor element of the present invention is desired to have properties such as flexibility, light weight, low cost, and shock resistance, it is preferred that a plastic sheet be used as a support.

Examples of the plastic sheet include sheets formed of materials such as polyethylene terephthalate, polyethylene naphthalate, polyether sulfone, polyether imide, polyether ether ketone, polyphenylene sulfide, polyacrylate, polyimide, polycarbonate, cellulose triacetate, and cellulose acetate propionate.

«Electron-Donating Compound Layer and Electron-Accepting Compound Layer»

The two organic compounds for use in the present invention are preferably a combination of an electron-donating compound and an electron-accepting compound. The electron-donating compound layer or electron-accepting compound layer can be formed by forming a thin film out of the electron-donating compound or electron-accepting compound by vapor deposition.

In order to form the electron-donating compound layer or electron-accepting compound layer, the target compound is heated in vacuum to make it vapor, and depositing on the intended region to form a thin layer. Alternatively, the target compound can be made dissolved in a solvent such as dichloromethane, tetrahydrofuran, chloroform, toluene, dichlorobenzene and xylene, and the solution may be applied by a solution process such as spin coating, and ink jetting to form a thin layer.

A thickness of each of the first organic compound layer and the second organic compound layer is not restricted, but is suitably selected so as to form a uniform thin film, i.e., a thin film having no gap or hole that adversely affects the carrier transporting performance of the organic semiconductor layer. The thickness of each layer is generally 1 μm or thinner, particularly preferably 5 nm to 200 nm.

- Tetrathiafulvalene Derivative -

Specific examples of the tetrathiafulvalene derivative especially effective for the present invention will be described below.

In the general formula I, R1 to R16 are as follows: a hydrogen atom, a halogen atom, a substituted or unsubstituted alkyl group, a substituted or unsubstituted alkoxy group, or a substituted or unsubstituted thioalkoxy group, and R1 to R16 are the same or different from each other.

The substituted or unsubstituted alkyl group is a straight-chain, branched, or cyclic alkyl group having one or more carbon atoms, and such alkyl group may further contain a halogen atom (e.g., a fluorine atom, a chlorine atom, a bromine atom, and an iodine atom), a cyano group, a phenyl group, or a phenyl group substituted with a straight chain or branched alkyl group.

Specific examples thereof include a methyl group, an ethyl group, a n-propyl group, an i-propyl group, a t-butyl group, a s-butyl group, an n-butyl group, an i-butyl group, a pentyl group, a hexyl group, a heptyl group, an octyl group, a nonyl group, a decyl group, an undecyl group, a dodecyl group, a tridecyl group, a tetradecyl group, a pentadecane group, a hexadecyl group, a heptadecyl group, an octadecyl group, a 3,7-dimethyloctyl group, a 2-ethylhexyl group, a trifluoromethyl group, a trifluorooctyl group, a trifluorododecyl group, a trifluorooctadecyl group, a 2-cyanoethyl group, a benzyl group, a 4-chlorobenzyl group, a 4-methylbenzyl group, a cyclopentyl group, and a cyclohexyl group.

Moreover, in the case where any of R1 to R16 is a substituted or unsubstituted alkoxy group or thioalkoxy group, specific examples thereof include alkoxy groups or thioalkoxy groups in which an oxygen atom or sulfur atom is inserted into the bonding position of the aforementioned alkyl group.

Specific examples of the derivative for use in the present invention are as follows:

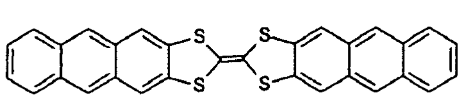
(1)

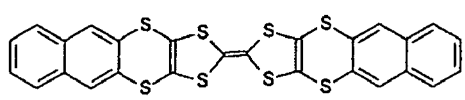
(2)

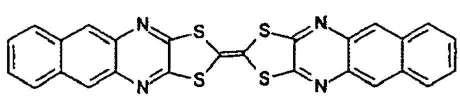
(3)

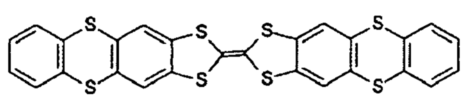
(4)

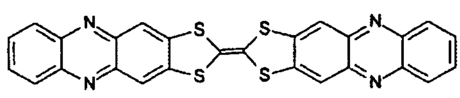
(5)

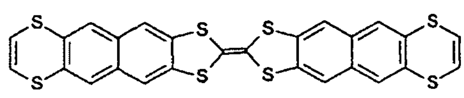
(6)

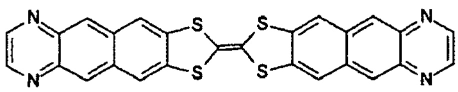 (7) 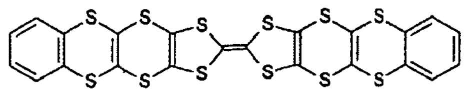 (8)

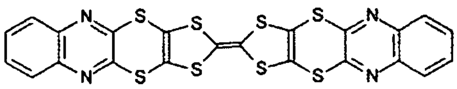 (9) 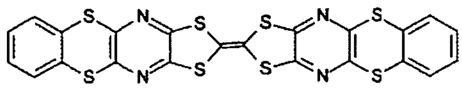 (10)

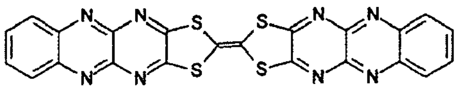 (11) 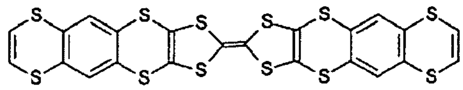 (12)

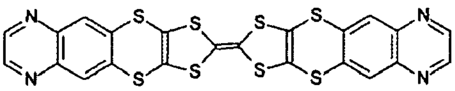 (13) 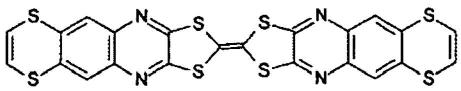 (14)

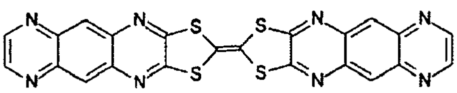 (15) 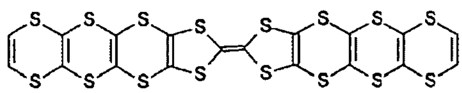 (16)

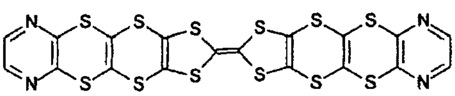 (17) 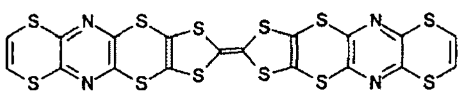 (18)

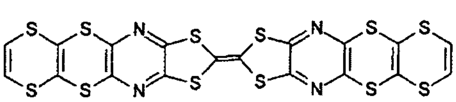 (19) 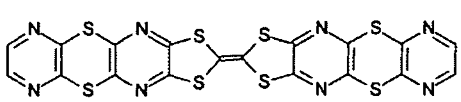 (20)

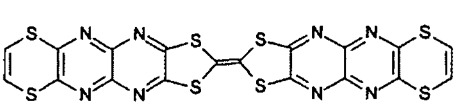 (21) 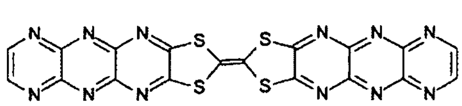 (22)

These tetrathiafulvalene derivatives can be used independently or in combination in accordance with the conventional practices. These derivatives can be synthesized by the synthesis methods know in the art. Moreover, those synthesized by the synthesis method proposed by the present inventors (see Japanese Patent Application Filing Nos. 2009-073990, 2010-000319, and 2010-026729) may be used (the disclosures of which are herein incorporated by reference).

For example, a tetrathiafulvalene derivative can be produced by allowing a raw material, that is a 1,3-dithiol-2-one compound to proceed with a coupling reaction (see J. Org, Chem., 2000, 65, 5794-5805). In this case, the 1,3-dithiol-2-one compound of the raw material can be obtained, for example, by the following manner. A quinone compound is obtained by the reaction disclosed in J. Org. Chem. 1994, 59, 6519-6527, Chem. Commun. 1998, 361-362, Chem.

Commun. 1998, 2197-2198, Tetrahedron Letters 2000, 41, 2091-2095, i.e. the conventional Diels-Alder reaction (with Lewis acid as a catalyst) between the dienophile and the diene corresponding to the intended structure; a carbonyl group of the quinone compound is reduced to a hydroxyl compound by a metallic hydrogen compound, and this hydroxyl compound was turned into a 1,3-dithiol-2-thione compound by intermolecular dehydration; and this compound is then transformed into a 1,3-dithiol-2-one compound (see the aforementioned J. Org, Chem., 2000, 65, 5794-5805, for this transformation).

« Insulating Film»

Various insulating film materials can be used for the insulating film for use in the organic semiconductor element of the present invention. Examples thereof include inorganic insulating materials such as silicon oxide, silicon nitride, aluminum oxide, aluminum nitride, titanium oxide, tantalum oxide, tin oxide, vanadium oxide, barium-strontium-titanium oxide, barium-titanium-zirconium oxide, lead-zirconium-titanium oxide, lead lanthanum titanate, strontium titanate, barium titanate, barium magnesium fluoride, bismuth-niobium-tantalum oxide and yttrium trioxide.
Moreover, a polymer compound can also be used as such insulating material, and examples thereof include polyimide, polyvinyl alcohol, polyvinyl phenol, polyester, polyethylene, polyphenylene sulfide, unsubstituted or halogen atom-substituted polyparaxylylene, polyacrylonitrile and cyanoethylpullulan.
These insulating materials may be used in combination. The insulating material is not particularly limited, but it is preferred to use an insulating material having a high dielectric constant and a low conductivity.
Examples of a method forming the insulating film using the aforementioned material include: a dry process such as chemical vacuum deposition (CVD), plasma CVD, plasma polymerization, and vapor deposition; and a wet coating process such as spray coating, spin coating, dip coating, inkjet coating, casting, blade coating, and bar coating.
Surface Treatment of Gate Insulating Film by HMDS etc.
The organic semiconductor element of the present invention may contain a thin organic film provided between the insulating film and the electron-donating compound layer, or between the insulating film and the electron-accepting compound layer for improving the adhesion between them, reducing the gate voltage, reducing leak current. The thin organic film is suitably selected depending on the intended purpose without any restriction, provided that it does not chemically affect the organic semiconductor active region. For example, an organic molecular film or thin polymer film can be used as the thin organic film.
Examples of the material used for the organic molecular film include a coupling agent such as octadecyl trichlorosilane, octyltrichlorosilane, hexamethylene disilazane (HMDS). Moreover, examples of the material used for the thin polymer film include the aforementioned polymer insulating film materials, and these materials may also function as an insulating film. Furthermore, the thin organic film may be subjected to an anisotropic treatment by rubbing or the like.

«Gate Electrode»

The gate electrode for use in the organic semiconductor element of the present invention is suitably selected depending on the intended purpose without any restriction, provided that it is formed of a conductive material. Examples of such conductive material include:

platinum, gold, silver, nickel, chromium, copper, iron, tin, antimony, lead, tantalum, indium, aluminum, zinc, magnesium, and alloys thereof;
conductive metal oxides such as indium/tin oxides; organic and inorganic semiconductors in which conductivity is improved by doping, etc., such as a silicon single crystal, polysilicon, amorphous silicon, germanium, graphite, polyacetylene, polyparaphenylene, polythiophene, polypyrrol, polyaniline, polythienylene vinylene, polyparaphenylene vinylene,
complexes consisting of polyethylene dioxythiophene and polystyrene sulfonic acid. Moreover, an organic electrode containing the electron-donating compound and the electron-accepting compound may also be used as the gate electrode.

Examples of the method for forming the electrode include: a method for forming an electrode in which the aforementioned material is served as a raw material and deposited by vapor deposition or sputtering to form a conductive thin film, and forming an electrode from the conductive thin film by conventional photolithography or lift-off processing; a method in which the conductive thin film is subjected to hot printing on a metal leaf such as of aluminum or cupper; and a method in which the conductive thin film is etched by using a resist formed by inkjet coating or the like. Alternatively, a conductive polymer solution or dispersion liquid, or conductive particle dispersion liquid may be directly applied patternwise by inkjet coating, or the conductive polymer coating film may be formed into a pattern by lithography or laser abrasion. Moreover, a method in which an ink containing a conductive polymer or conductive particles, conductive paste,

or the like is patterned by a printing methods such as relief printing, intaglio printing, lithography, and screen printing, can be used.

«Extraction Electrode and Protective Layer»

An organic semiconductor element of the present invention may have an extraction electrode provided from each electrode, if necessary.
A protective layer may be provided to the organic semiconductor element for protecting from moisture, air, or gas, or protection in the course of an integration of a device, if necessary.

<Applied Device>

According to the present invention, a p-type organic semiconductor, n-type organic semiconductor, a p-type or n-type organic semiconductor active region, and an organic electrode can be produced by using the two organic compounds, and these can be used as various circuits.
Moreover, the organic semiconductor element can be used as an element for driving a display element such as liquid crystal, electroluminescence, electrochromic, and electrophoretic migration. When such elements are integrated, it is possible to produce a display referred to as "electronic paper". Moreover, it is also possible that the organic semiconductor elements of the present invention are integrated to produce an IC, and such IC is used as a device, such as an IC tag.

Examples

The present invention will be more concretely and specifically explained through Examples below, but these Examples are merely for explaining the present invention and shall not be construed as limiting the present invention.

(Example 1)

An organic semiconductor element having a top-contact structure shown in FIG. 1D was prepared using bis (anthra[2,3-d]) tetrathiafulvalene (1) in the following manner.
An n-type silicon substrate provided with a thermal oxidation film having the thickness of 300 nm was washed by immersing the substrate in strong sulfuric acid for 24 hours. The washed silicon substrate was immersed in a toluene solution of a silane coupling agent (i.e. octyltrichlorosilane) (1 mM), and subjected to ultrasonication for 5 minutes to form a monomolecular film on the surface of silicone oxide film.
To the substrate prepared above, bis(anthra[2,3-d]) tetrathiafulvalene (1) was deposited on the entire surface of the substrate by vacuum deposition (back pressure: up to $10^{-4}$Pa, deposition rate: 0.1 Å/*s*, film thickness: 25 nm) to form a film to thereby form a first organic compound layer. Thereafter, fullerene was deposited through a metal mask having a shape of electrode by vacuum deposition (back pressure: up to $10^{-4}$ Pa, deposition rate: 0.1 Å/s, film thickness: 40 nm) to form a film to thereby form a second organic compound layer. In this manner, a top-contact organic semiconductor element was produced. Here, the shape of the electrode formed of the fullerene using the metal mask had a channel length of 50 μm, and a channel width of 2 mm.
The electric properties of the thus obtained field-effect transistor (FET) element was evaluated by a semiconductor parameter analyzer B1500, manufactured by Agilent Technologies, and it was found that the FET exhibited the properties of a p-type organic thin-film transistor. The probing to the source electrode and the drain electrode for the evaluation was performed at the probing position 1 shown in FIG. 2A. the current-voltage (I-V) characteristics of the organic thin-film transistor are shown in FIG. 3. Based on the saturation region in the FIG. 3, the electron field-effect mobility was obtained.
Note that the following formula was used for the calculation of the electron field-effect mobility of the organic thin-film transistor.

$$Ids = \mu CinW (Vg - Vth) 2/2L \quad \text{Calculation Formula (1)}$$

In the formula above, Cin is a capacitance per unit area of a gate insulating film, W is a channel width, L is a channel length, Vg is a gate voltage, Ids is a source-drain current, μ is a field effect mobility and Vth is a gate threshold voltage at which a channel begins to be formed.
The electron field-effect mobility of the prepared organic thin-film transistor was 0.0062 $cm^2$/Vs.

(Example 2)

The organic semiconductor element prepared in Example 1 was evaluated in terms of electric characteristics in the same manner as in Example 1, provided that the probing positions to the source electrode and drain electrode were changed to the probing position 2 shown in FIG. 2B. As a result, it was found that the organic semiconductor element showed the characteristics of a p-type organic thin-film transistor. The current-voltage (I-V) characteristics of the organic thin-film transistor were shown in FIG. 4.

The electron field-effect mobility of the organic thin-film transistor was 0.005 $cm^2$/Vs.

(Example 3)

An organic semiconductor element having a bottom-contact structure, i.e. the structure shown in FIG. 1D, was prepared in the following manner using bis(anthra[2,3-d]) tetrathiafulvalene (1).

To a n-type silicon substrate which had been processed in the same manner as in Example 1, bis(anthra[2,3-d]) tetrathiafulvalene (1) was deposited through a metal mask in the shape of an electrode by vacuum deposition (back pressure: up to $10^{-4}$ Pa, deposition rate: 0.1 Å/*s,* film thickness: 25 nm) to form a first organic compound layer in the shape of an electrode. Then, on the entire surface of the substrate, fullerene was deposited by vacuum deposition (back pressure: up to $10^{-4}$ Pa, deposition rate: 0.1 Å/s, film thickness: 40 nm) to form a second organic compound layer to thereby prepare an organic semiconductor element of a bottom-contact structure. The electrode shape of bis(anthra [2,3-d]) tetrathiafulvalene (1) provided through the metal mask had a channel length of 50 μm, and a channel width of 2 mm.

Electric characteristics of the prepared organic semiconductor element were evaluated in the same manner as in Example 1, and as a result it was found that the prepared organic semiconductor element exhibited characteristics of a n-type organic thin-film transistor. The current-voltage (I-V) characteristics of the organic thin-film transistor are shown in FIG. 5.

The electric field-effect mobility of the organic thin-film transistor was 0.003 $cm^2$/Vs.

The results show that in Example 1 a charge-transfer complex was formed at an interface between the layer of bis(anthra[2,3-d])tetrathiafulvalene and the layer of fullerene, and the resulting laminated film functioned as an organic electrode. Moreover, the results show that the excellent characteristics as a p-type organic semiconductor element of bis(anthra[2,3-d])tetrathiafulvalene provided surrounding were used as the organic semiconductor active region. Moreover, in Example 2, the similar electron field-effect mobility to that of Example 1 was obtained even through the probing position was relocated by 1 cm compared to that in Example 1, which clearly showed that the charge-transfer complex formed at the interface of the layer of bis(anthra[2,3-d])tetrathiafulvalene and the layer of fullerene was excellent as an organic electrode.

In Example 3, bis(anthra[2,3-d])tetrathiafulvalene was provided in the shape of an electrode, followed by forming the film of fullerene on the entire surface of the substrate. As a result, only the portion in the shape of the electrode where bis(anthra[2,3-d])tetrathiafulvalene was provided functioned as an organic electrode, and the surrounding area where fullerene was provided showed excellent characteristics of an n-type organic semiconductor element, and such excellent characteristics were used as an organic semiconductor active region of an organic semiconductor element.

(Example 4)

A p-type organic semiconductor and n-type organic semiconductor were both selectively prepared at the same time as preparing an organic electrode. Specific production method thereof will be explained with reference to FIGs. 6A to 6C hereinafter.

Washing of a substrate and pretreatment were performed in the same manner as in Example 1 (Step 1, illustrated in FIG. 6A). Next, a layer of bis(anthra[2,3-d]) tetrathiafulvalene (1) was provided in the same manner as in Example 1 or 3, provided that the layer was provided in the shape of an electrode in the region where a n-type organic semiconductor would be formed, and the layer was provided to cover the entire portion where organic electrodes and an organic semiconductor active region were intended to be provided in the region where a p-type organic semiconductor would be formed (Step 2, illustrated in FIG. 6B). Thereafter, a layer of fullerene was formed in the same manner as in Example 1 or 3, provided that the layer was provided so as to cover at least the formed electrode shapes and the space formed by the electrode shapes in the region where a n-type organic semiconductor element would be formed, and the layer was provided in the shape of an electrode in the region where a p-type semiconductor element would be formed (Step 3, illustrated in FIG. 6C).

Electric characteristic of each element were evaluated in the same manner as in Example 1, and as a result it was found that the portion of the n-type organic semiconductor element exhibited the similar current-voltage (I-V) characteristics to that of the organic semiconductor element shown in FIG. 5, and the portion of the p-type organic semiconductor element exhibited the similar current-voltage (I-V) characteristics to that of the organic semiconductor element

shown in FIG. 3.

Namely, in accordance with the present invention, both p-type and n-type organic semiconductor elements can be formed by simply forming a single layer using each of two organic materials (i.e. two layers in total), as well as forming an organic electrode at the same time, and thus an organic semiconductor element of excellent flexibility can be easily obtained.

(Example A)

A laminated film was prepared using bis(anthra[2,3-d]) tetrathiafulvalene (1) in the following manner.

An n-type silicon substrate provided with a thermal oxidation film having a thickness of 300 nm was immersed in strong sulfuric acid for 24 hours for washing. The washed silicon substrate was immersed in a toluene solution of a silane coupling agent (i.e. octyltrichlorosilane) (1 mM), and subjected to ultrasonication for 5 minutes to form a monomolecular film on the surface of silicone oxide film.

To the substrate prepared above, bis(anthra[2,3-d]) tetrathiafulvalene (1) was deposited on the entire surface of the substrate by vacuum deposition (back pressure: up to $10^{-4}$Pa, deposition rate: 0.1 Å/*s,* film thickness: 25 nm) to form a tetrathiafulvalene derivative layer. Successively, fullerene was deposited by vacuum deposition (back pressure: up to $10^{-4}$ Pa, deposition rate: 0.1 Å/s*,* film thickness: 40 nm) to thereby form an electron-accepting compound layer.

In order to measure electric conductivity of the laminated film, gold was deposited through a shadow mask by vacuum deposition (back pressure: up to $10^{-4}$ Pa, deposition rate: 1 Å/s to 2 Å/s, film thickness: 50 nm) to thereby form a cathode and an anode (channel length: 50 μm, channel width: 2 mm).

The thus obtained laminated film was evaluated in terms of its current-voltage characteristics by means of a semiconductor parameter analyzer B1500, manufactured by Agilent Technologies, and it was found that the laminated film exhibited high electric conductivity, 0.2 S/cm.

(Example B)

A laminated film was prepared in the same manner as in Example A, provided that $F_4$TCNQ was used for an electron-accepting layer, and the current-voltage measurement was performed in the same manner as in Example A.

(Example C)

A laminated film was prepared in the same manner as in Example A, provided that $F_2$TCNQ was used for an electron-accepting layer, and the current-voltage measurement was performed in the same manner as in Example A using the prepared laminated film.

(Example D)

A laminated film was prepared in the same manner as in Example A, provided that $F_1$TCNfQ was used for an electron-accepting layer, and the current-voltage measurement was performed in the same manner as in Example A using the prepared laminated film.

(Comparative Example A)

A laminated film was prepared in the same manner as in Example A, provided that 5,5'-bis(4-hexyloxyphenyl)-2,2'-bithiophene: (23) having the structure shown below was used as the electron-donating compound instead of (anthra [2,3-d]) tetrathiafulvalene (1), and the current-voltage measurement was performed in the same manner as in Example A using the prepared laminated film.

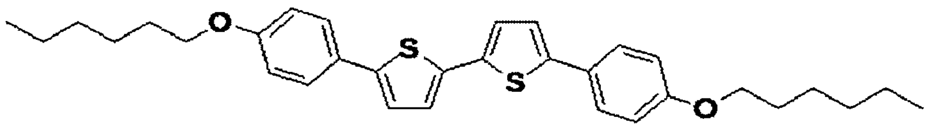

(23)

The results of Examples A to D and Comparative Example A are shown in Table 1. In Table 1, "B" is the case where the ohmic contact (I-V curve is linear in the graph) was confirmed because of the formation of a charge-transfer

complex at interface in the laminated film, as well as high electric conductivity of 0.001 S/cm or higher was confirmed, "A" is the case where particularly high electric conductivity (0.1 S/cm or higher) of the laminated film was confirmed, and "C" is a case where low conductivity (less than 0.001 S/cm) of the laminated film was confirmed.

Table 1

| | Conductivity |
|---|---|
| Example A | A |
| Example B | B |
| Example C | B |
| Example D | B |
| Comparative Example A | C |

Based on the results above, it was found that the tetrathiafulvalene expressed by the general formula (I) formed a charge-transfer complex layer regardless of a material of an electron-accepting compound layer, owing to the high electron-donating ability of the tetrathiafulvalene expressed by the general formula (I), and the resultant attained high electric conductivity. Moreover, the laminated film of Comparative Example A used 5,5'-bis(4-hexyloxyphenyl)-2,2'-bithiophene (23) of low electron-donating ability, and in this case a charge-transfer complex was not formed even through fullerene that had high electron-accepting ability was used in combination, and the resulting laminated film attained low electric conductivity. The current-voltage measurement of Example A, the electric conductivity of which was particularly high, and the current-voltage measurement of Comparative Example A are respectively shown in FIGs. 7 and 8.

As it is clear from the comparison between FIG. 8 and FIG. 7, in Comparative Example A, linear I-V characteristics (ohmic contact) were lost, and the electric conductivity thereof was order of the powder of -5 (S/cm), which was substantially the same to the electric conductivity of an insulating film. As shown above, a charge-transfer complex film is not formed in the case where electron-donating ability of an electron-donating layer even though the identical electron-accepting layer is used.

(Example E)

An organic semiconductor element having a bottom-contact structure shown in FIG. 1C was prepared using bis(anthra[2,3-d]) tetrathiafulvalene (1) in the following manner.

An n-type silicon substrate provided with a thermal oxidation film having the thickness of 300 nm was immersed in strong sulfuric acid for 24 hours for washing. The washed silicon substrate was immersed in a toluene solution of a silane coupling agent (i.e. octyltrichlorosilane) (1 mM), and subjected to ultrasonication for 5 minutes to form a monomolecular film on the surface of silicone oxide film.

To the substrate prepared above, bis(anthra[2,3-d]) tetrathiafulvalene (1) was deposited through a shadow mask by vacuum deposition (back pressure: up to $10^{-4}$ Pa, deposition rate: 0.1 Å/*s,* film thickness: 25 nm) to form a film. Successively, fullerene was deposited by vacuum deposition (back pressure: up to $10^{-4}$ Pa, deposition rate: 0.1 Å/*s,* film thickness: 40 nm) to form a film, to thereby form an organic electrode (channel length: 50 $\mu$m, channel width: 2 mm) of the bottom-contact type organic semiconductor element. The obtained organic electrode was served as a source electrode and a drain electrode.

Then, the shadow mask to give an electrode pattern was replaced with a shadow mask to give a pattern of an organic semiconductor active layer shown in FIGs. 2A and 2B under the condition where the laminated film was not exposed to oxygen or moisture, and an organic semiconductor active layer was formed by vacuum deposition (back pressure: up to $10^{-4}$ Pa, deposition rate: 0.1 Å/*s,* film thickness: 50 nm). As a material of the organic semiconductor active layer, pentacene was used.

The electric properties of the thus obtained field-effect transistor (FET) element was evaluated by a semiconductor parameter analyzer B1500, manufactured by Agilent Technologies, and it was found that the FET exhibited the properties of a p-type organic thin-film transistor. The probing to the source electrode and the drain electrode for the evaluation was performed at the probing position 1 shown in FIG. 2A. The current-voltage (I-V) characteristics of the organic thin-film transistor are shown in FIG. 9. Based on the saturation region in the FIG. 9, the electron field-effect mobility was obtained.

Note that the following formula was used for the calculation of the electron field-effect mobility of the organic thin-film transistor.

$$Ids=\mu CinW(Vg-Vth)2/2L$$ Calculation Formula (1)

In the formula above, Cin is a capacitance per unit area of a gate insulating film, W is a channel width, L is a channel length, Vg is a gate voltage, Ids is a source-drain current, $\mu$ is a field effect mobility and Vth is a gate threshold voltage at which a channel begins to be formed.
The electron field-effect mobility of the prepared organic thin-film transistor was 0.0012 $cm^2/Vs$.

(Example F)

An organic semiconductor element was obtained using an organic electrode prepared in the same manner as Example E provided that bis(anthra[2,3-d]) tetrathiafulvalene (1) was used for an organic semiconductor active layer. The electric characteristics thereof were evaluated in the same manner as in Example E, and as a result it was found that the prepared organic semiconductor element exhibited characteristics of a p-type transistor element. Moreover, the electron field-effect mobility thereof was measured in the same manner as in Example E, and the electron field-effect mobility of the prepared organic semiconductor element was 0.0062 $cm^2/Vs$.
The current-voltage (I-V) characteristics of this organic thin-film transistor are shown in FIG. 10.

(Example G)

An organic semiconductor element was obtained using an organic electrode prepared in the same manner as Example E provided that fullerene was used for an organic semiconductor active layer. The electric characteristics thereof were Example E, and as a result it was found that the prepared organic semiconductor element exhibited characteristics of a n-type transistor element. Moreover, the electron field-effect mobility thereof was measured in the same manner as in Example E, and the electron field-effect mobility of the prepared organic semiconductor element was 0.0030 $cm^2/Vs$.
The current-voltage (I-V) characteristics of this organic thin-film transistor are shown in FIG. 11.

(Example H)

The organic semiconductor element prepared in Example F was evaluated in terms of electric characteristics in the same manner as in Example B, provided that the probing positions to the source electrode and drain electrode were changed to the probing position 2 shown in FIG. 2B. As a result, it was found that the organic semiconductor element showed the characteristics of a p-type organic thin-film transistor. Moreover, the electron field-effect mobility thereof was measured in the same manner as in Example E, and the electron field-effect mobility of the prepared organic semiconductor element was 0.0050 $cm^2/Vs$.
The current-voltage (I-V) characteristics of this organic semiconductor element are shown in FIG. 12.

(Comparative Example B)

An organic semiconductor element was prepared in the same manner as in Example E, provided that 5,5'-bis (4-hexyloxyphenyl)-2,2'-bithiophene (23) shown below was used as the electron-donating compound instead of bis (anthra[2,3-d]) tetrathiafulvalene (1), and properties of the prepared organic semiconductor element was evaluated in the same manner as in Example E. As a result, the prepared organic semiconductor element did not exhibit properties as an organic semiconductor element.

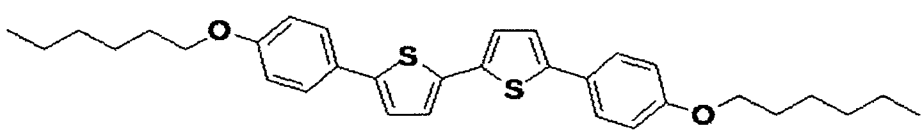

(23)

From the results of Examples F and G, it was found that the laminated film of the layer of tetrathiafulvalene derivative and the electron-accepting layer functioned as an organic electrode, which transported both holes and electrons. Moreover, in Example H, influence of the resistance by the electrode was observed by relocating the probing position by 1 cm, the amperage was hardly affected, which clearly showed that the laminated film of the tetrathiafulvalene derivative expressed by the general formula I and the electron-accepting compound sufficiently functioned as an organic electrode.

In Comparative Example B, fullerene that had high electron-accepting ability was deposited on 5,5'-bis(4-hexyloxyphenyl)-2,2'-bithiophene that had low electron-donating ability to form a laminated film, but the resulting laminated film did not function as an organic electrode at all. The aforementioned results show that the strong electron-donating ability of the tetrathiafulvalene derivative expressed by the general formula (I) plays a great role in the organic electrode of the present invention.

## Claims

1. An organic semiconductor element, comprising:

   a source electrode containing a first organic compound layer and a second organic compound layer, at least one of the layers having an organic semiconductor active region; and
   a drain electrode containing the first organic compound layer and the second organic compound layer.

2. The organic semiconductor element according to claim 1, wherein the first and second organic compounds are a combination of one electron-donating compound and one electron-accepting compound.

3. The organic semiconductor element according to claim 2, wherein the electron-donating compound is a tetrathiafulvalene derivative expressed by the following general formula I:

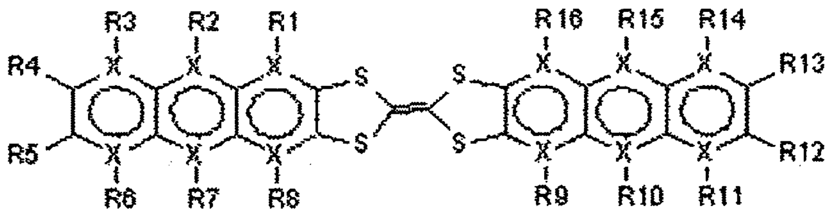

General formula I

where X is a carbon atom, a sulfur atom, or a nitrogen atom, and a plurality of X are the same or different from each other; and R1 to R16 are each a hydrogen atom, a halogen atom, a substituted or unsubstituted alkyl group, a substituted or unsubstituted alkoxy group, or a substituted or unsubstituted thioalkoxy group, and are the same or different from each other, provided that X is the carbon atom or the nitrogen atom.

4. The organic semiconductor element according to any of claims 2 and 3, wherein the electron-accepting compound is fullerene.

5. An organic electrode, comprising:

   a laminated film, in which a layer of a tetrathiafulvalene derivative expressed by the following general formula I and a layer of an electron-accepting compound are laminated:

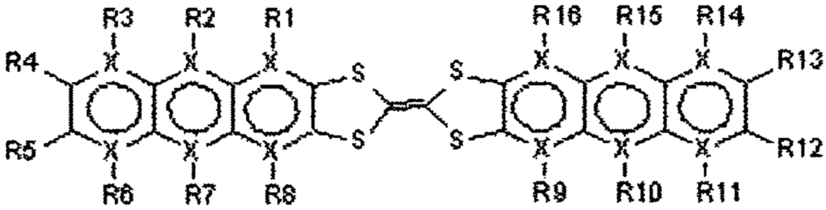

General formula I

where X is a carbon atom, a sulfur atom, or a nitrogen atom, and a plurality of X are the same or different from each other; and R1 to R16 are each a hydrogen atom, a halogen atom, a substituted or unsubstituted alkyl group, a substituted or unsubstituted alkoxy group, or a substituted or unsubstituted thioalkoxy group, and are the same or different from each other, provided that X is the carbon atom or the nitrogen atom.

**6.** The organic electrode according to claim 5, wherein the electron-accepting compound is fullerene.

FIG. 1A

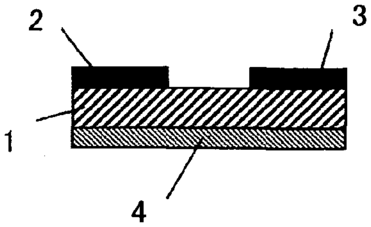


FIG. 1C

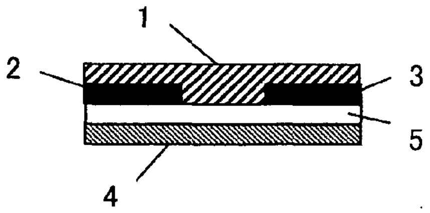


FIG. 1B

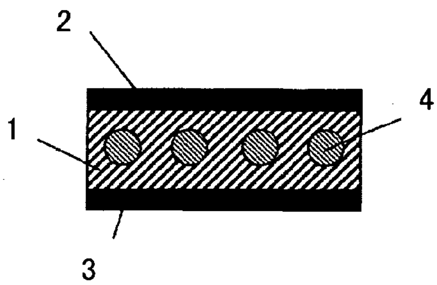


FIG. 1D

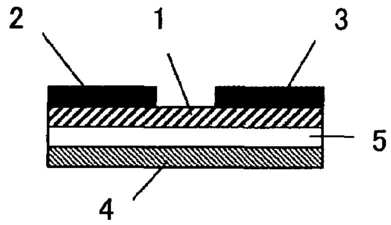


FIG. 2A

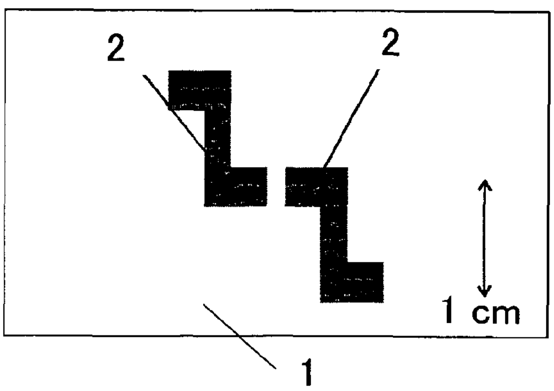


Probing position 1

FIG. 2B

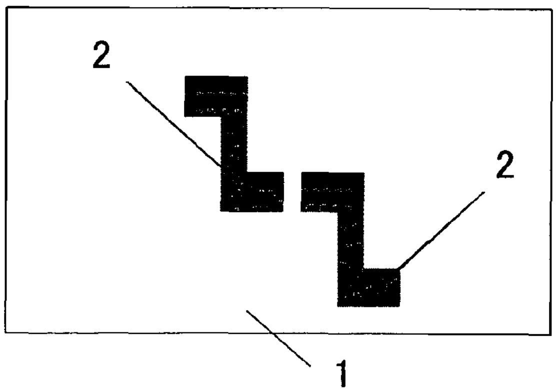


Probing position 2

FIG. 3

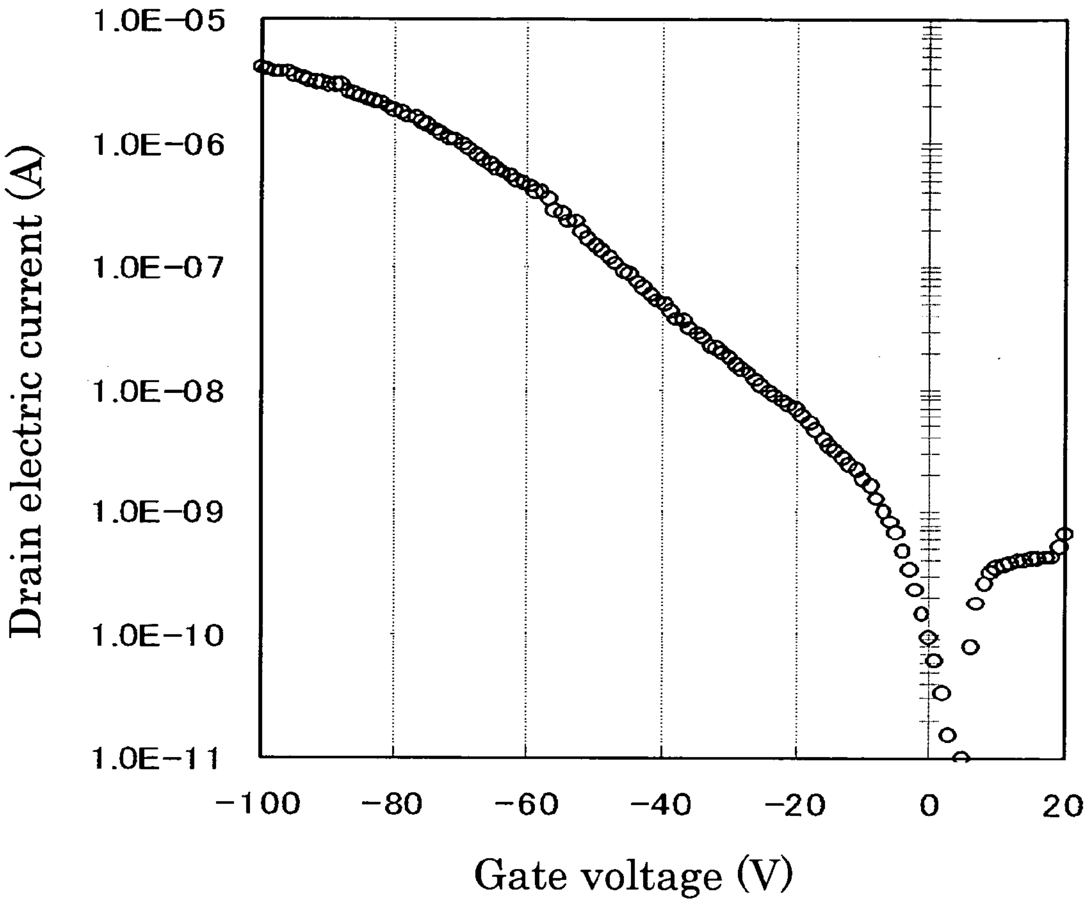
1.0E-05
1.0E-06
1.0E-07
1.0E-08
1.0E-09
1.0E-10
1.0E-11
Drain electric current (A)
-100
-80
-60
-40
-20
0
20
Gate voltage (V)

FIG. 4

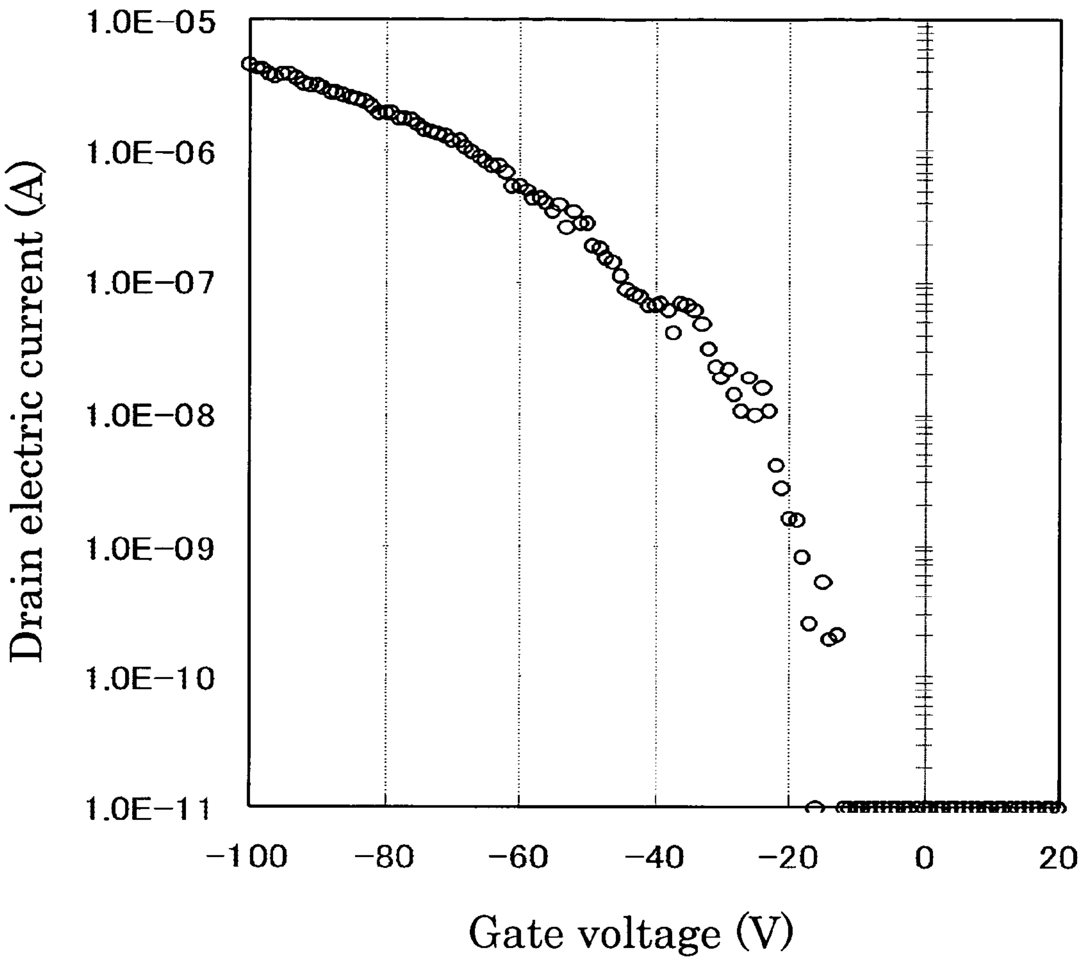
1.0E-05
1.0E-06
1.0E-07
1.0E-08
1.0E-09
1.0E-10
1.0E-11
Drain electric current (A)
-100
-80
-60
-40
-20
0
20
Gate voltage (V)

FIG. 5

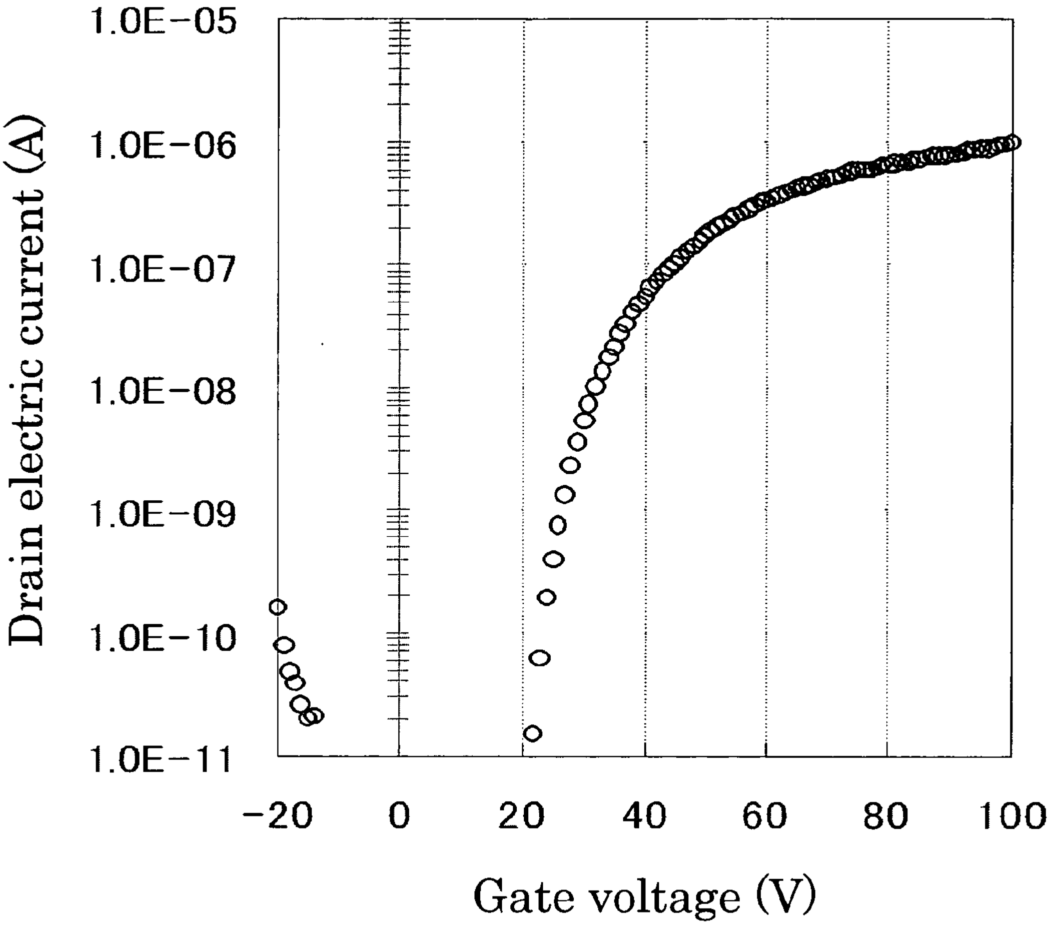
1.0E-05
1.0E-06
1.0E-07
1.0E-08
1.0E-09
1.0E-10
1.0E-11
Drain electric current (A)
-20
0
20
40
60
80
100
Gate voltage (V)

Top view Side view

FIG. 6A

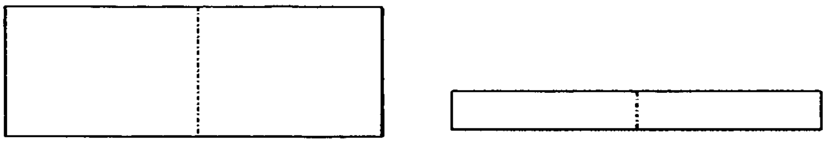

FIG. 6B

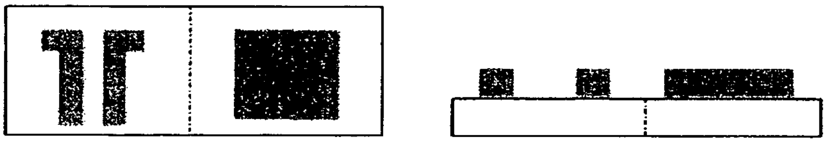

FIG. 6C

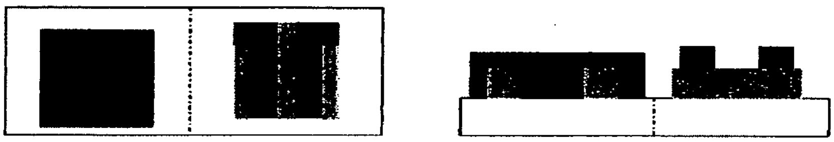

FIG. 7

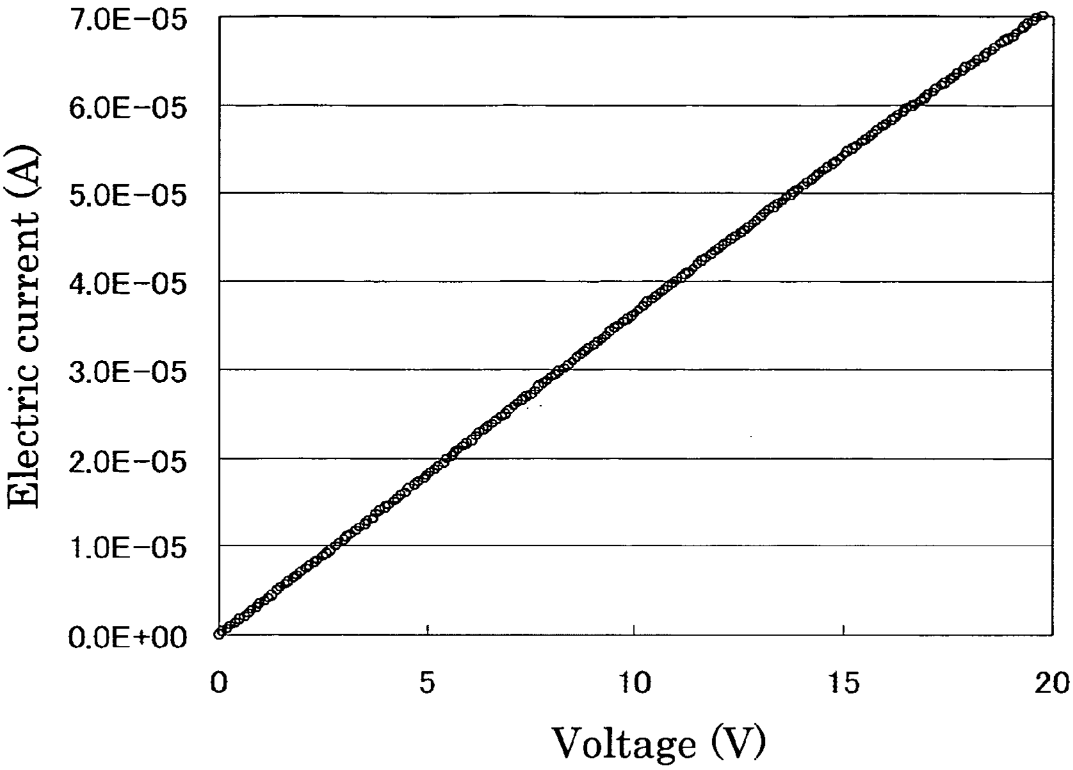
7.0E−05
6.0E−05
5.0E−05
4.0E−05
3.0E−05
2.0E−05
1.0E−05
0.0E+00
Electric current (A)
0
5
10
15
20
Voltage (V)

FIG. 8

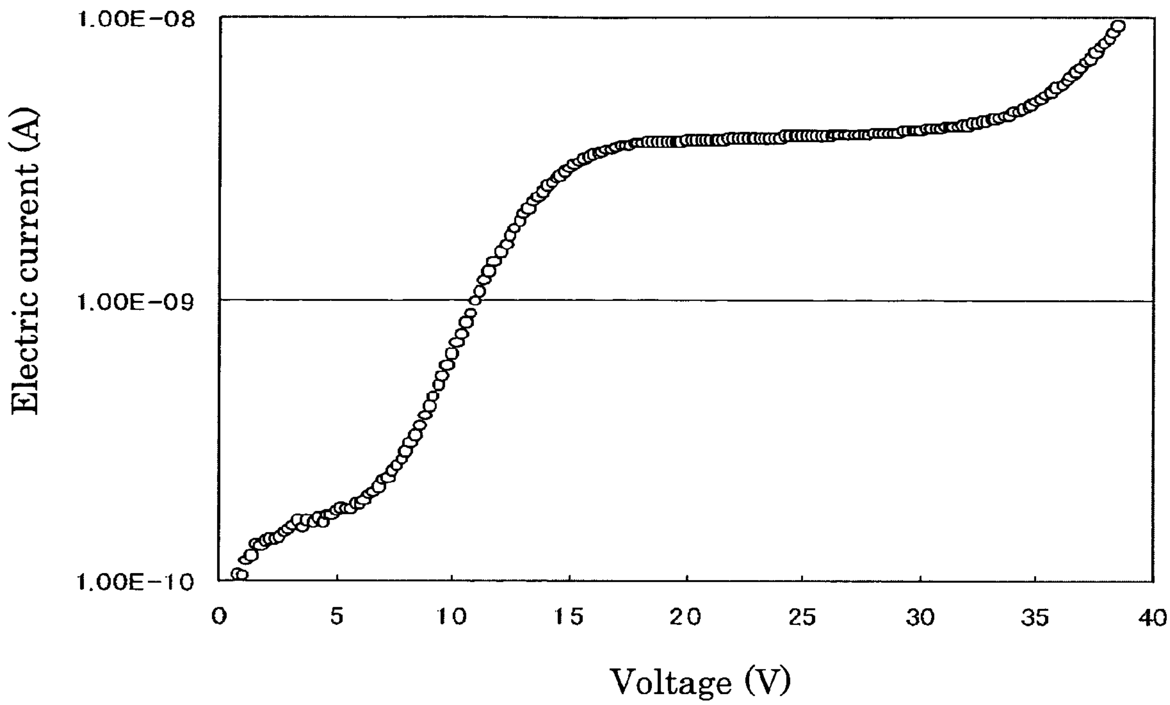
1.00E-08
1.00E-09
1.00E-10
Electric current (A)
0
5
10
15
20
25
30
35
40
Voltage (V)

FIG. 9

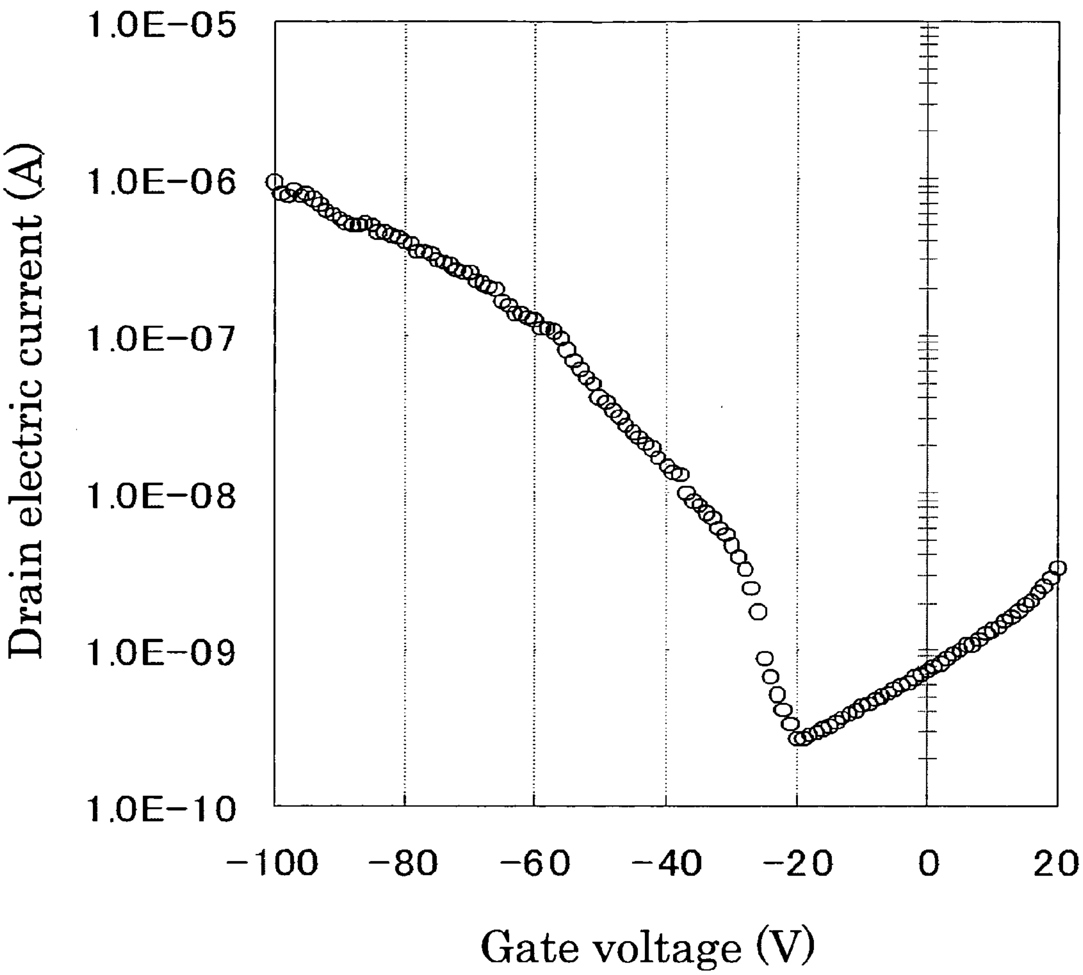
1.0E-05
1.0E-06
1.0E-07
1.0E-08
1.0E-09
1.0E-10
Drain electric current (A)
-100
-80
-60
-40
-20
0
20
Gate voltage (V)

FIG. 10

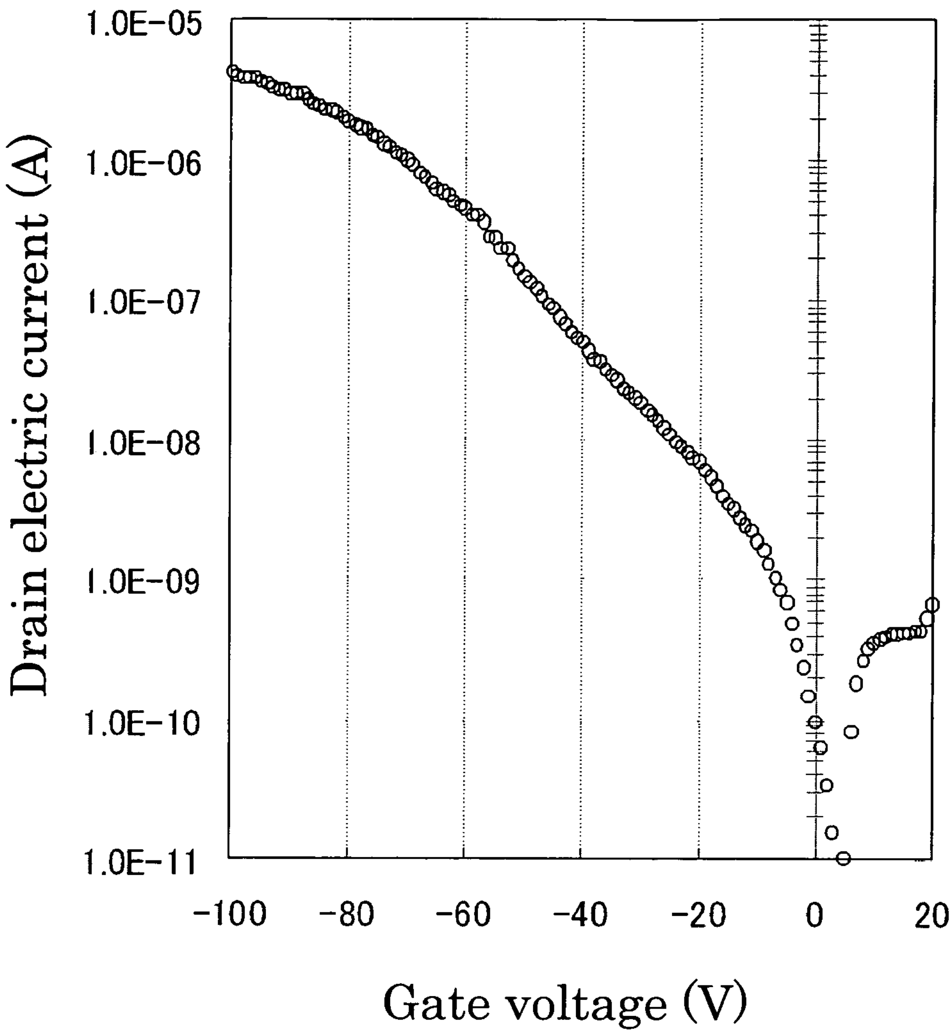
1.0E-05
1.0E-06
1.0E-07
1.0E-08
1.0E-09
1.0E-10
1.0E-11
Drain electric current (A)
-100
-80
-60
-40
-20
0
20
Gate voltage (V)

FIG. 11

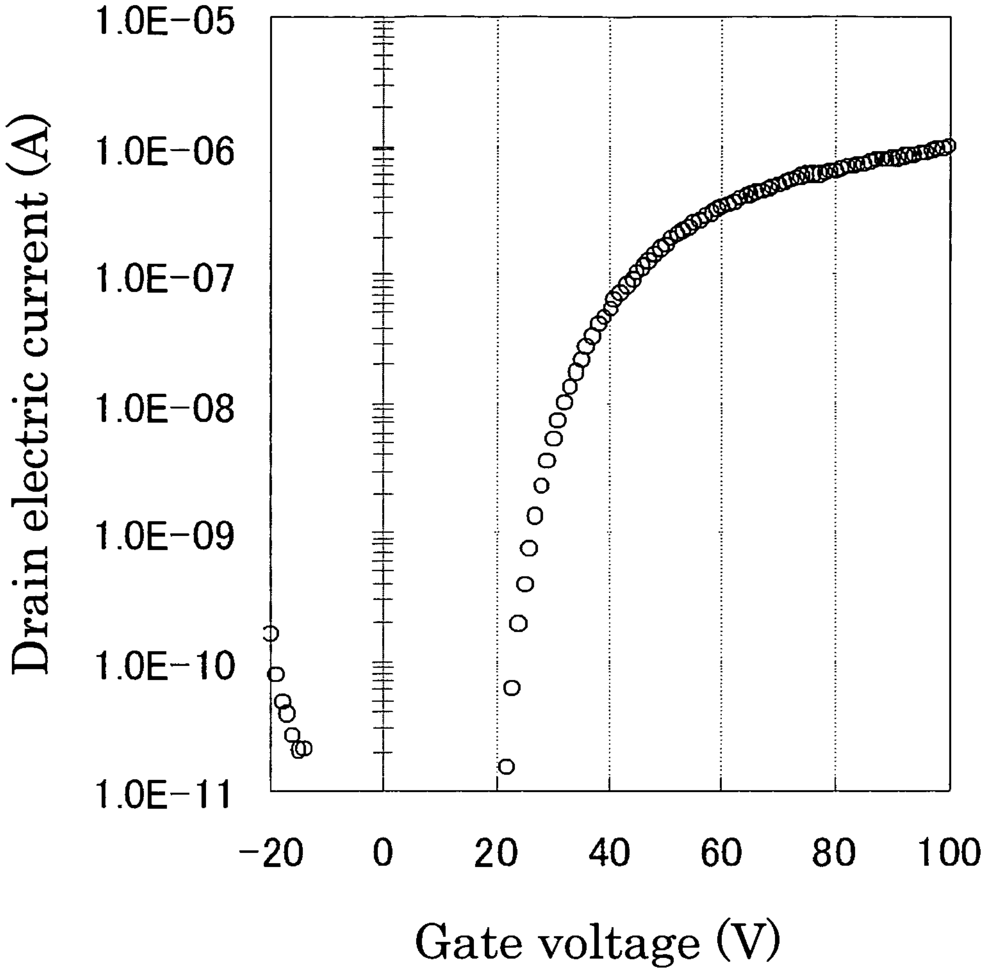
1.0E−05
1.0E−06
1.0E−07
1.0E−08
1.0E−09
1.0E−10
1.0E−11
Drain electric current (A)
−20
0
20
40
60
80
100
Gate voltage (V)

FIG. 12

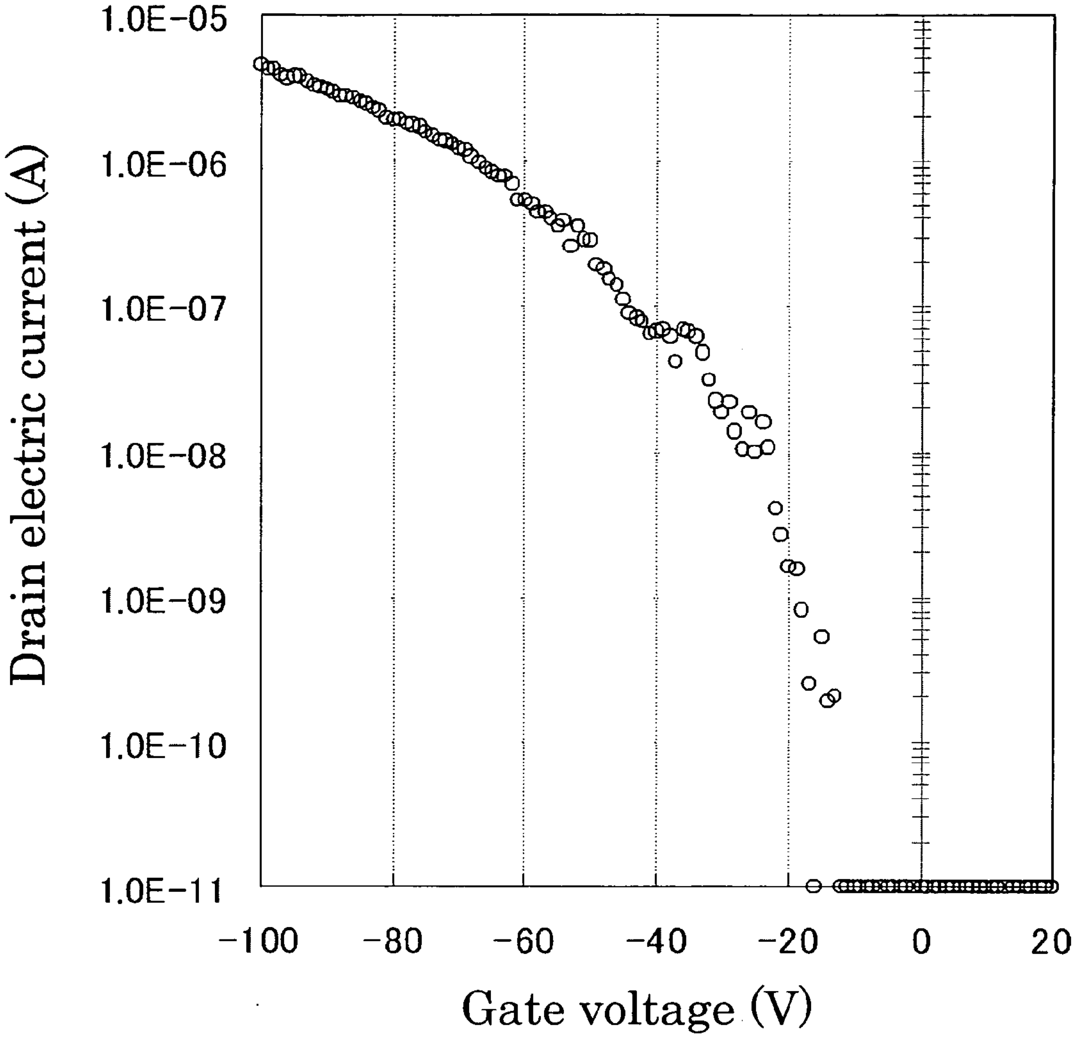
1.0E-05
1.0E-06
1.0E-07
1.0E-08
1.0E-09
1.0E-10
1.0E-11
Drain electric current (A)
-100
-80
-60
-40
-20
0
20
Gate voltage (V)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009073990 A
- JP 2010000319 A
- JP 2010026729 A

### Non-patent literature cited in the description


- *Appl. Phys. Lett.,* 2006, vol. 88, 073504
- *Adv. Materials,* 2007, vol. 19, 3248
- *Appl. Phys. Lette.,* 2006, vol. 88, 073504
- *Chem. Matter,* 2007, vol. 19, 6382
- *J. Org, Chem.,* 2000, vol. 65, 5794-5805
- *J. Org. Chem.,* 1994, vol. 59, 6519-6527
- *Chem. Commun.,* 1998, 361-362
- *Chem. Commun.,* 1998, 2197-2198
- *Tetrahedron Letters,* 2000, vol. 41, 2091-2095